# EUROPEAN PATENT SPECIFICATION

(11) **EP 0 329 097 B1**
(45) Date of publication and mention of the grant of the patent: **31.08.1994**
(21) Application number: 89102564.5
(22) Date of filing: 15.02.1989
(51) Int. Cl.: H01J 37/141, H01J 37/30, H01J 37/317

(54) **Magnetic object lens of electron beam exposure apparatus**
Magnetische Objektivlinse für Elektronenstrahl-Belichtungsgerät
Lentille magnétique d'un objectif pour appareil d'exposition par faisceau d'électrons

(30) Priority: 16.02.1988 JP 33088/88
(43) Date of publication of application: 23.08.1989
(73) Proprietor: FUJITSU LIMITED, Kawasaki-shi, Kanagawa 211 (JP)
(72) Inventor: Yasuda, Hiroshi c/o Fujitsu Limited, Kawasaki-shi Kanagawa 211 (JP); Suzuki, Masahiko, deceased (JP)
(74) Representative: Sunderland, James Harry

(56) References cited:
- US-A- 4 437 009
- US-A- 4 544 846
- SOLID STATE TECHNOLOGY, vol. 16, no. 7, July 1973, pages 25-29, Washingtion,US; R.T. MILLER: "Electron beam fabrication"

## Description

The present invention relates to electron beam exposure apparatus for electron beam lithography. Particularly, the invention relates to magnetic object lenses of electron beam apparatus.

Electron beam exposure systems are well-known for forming the minute patterns of large-scale integrated circuit semiconductor devices (LSIs). As integration density and complexity of LSIs increase, conventional optical lithographic techniques encounter a limit on their ability to produce extremely dense LSI circuit patterns, requiring the use of another pattern-making technique offering higher accuracy, for example electron beam lithography. The chief advantage of electron beam lithography is its high resolution capability. Problems due to diffraction effects inherent to optical lithography are resolved by the use of electron beam lithography because the equivalent wavelength of electrons in the 10 to 20 kilovolt energy range is less than 1 angstrom, which is substantially smaller than the wavelength of ultraviolet light. In addition, pattern-making is precisely controlled by computer and performed in short fabrication step flow, which lends itself to automation in high-volume production systems of intricate LSI semiconductor devices. By such automation, high throughput and stable and accurate pattern-making with high yield can be achieved.

Electron beam exposure systems are classified as either electron beam projection lithography systems or scanning electron beam lithography systems. In scanning electron beam lithography, a pattern is written with a fine electron beam, the deflection of which, and the turning on and off of which, is controlled by a computer. A scanning electron beam lithography system comprises: a beam-forming system in which electrons emitted from an electron source are formed into a fine beam having a round or rectangular cross-section; a beam deflection system in which the beam is deflected in a raster or vector scanning manner, and projected on to an object such as a wafer or a mask plate (hereinafter, for simplicity, the object will be taken to be a wafer); and a pattern-generation and control system for controlling the scanning of the electron beam and the movement of the object to form a required pattern on the wafer.

Generally, the scanning distance of the electron beam is limited within a short range, such as 2 mm, to avoid undesirable abberration. Accordingly, the overall surface of the wafer on which the pattern is to be formed is divided into small projection sub-areas to make circuit patterns thereon. Each sub-area is individually exposed to the electron beam, time sequentially, one sub-area after another. Naturally, the wafer must be moved in synchronization with the scanning of the associated electron beam. The wafer is usually mounted on a horizontal stage which is precisely movable in X-Y directions. Two major techniques are applied to movement of the wafer.

One technique is a "step and repeat" technique, which has been widely used, wherein individual patterns are made by deflecting the electron beam over a square field (sub-area) set on the wafer. After completion of pattern-making on one square field, the wafer is stepped to a new location and the electron beam is registered to a sample on the wafer, and then pattern exposure for the next square is effected.

The other technique is a "continuously moving stage" techniques, which is adopted, for example, in the EBES (electron beam exposure system) developed by Bell Telephone Laboratories, wherein the electron beam is raster-scanned in one direction, and the stage is moved continuously in another direction, usually perpendicular to the scanning direction. Details thereof are reported in IEEE Transactions of Electron Devices, Vol. RD-22, No. 7, pp 385 to 392, July 1975, "EBES": "A Practical Electron Lithographic System" by D. R. Heriott et al. The main advantage of the continuously moving stage technique is that pattern-writing and movement of the wafer can be performed at the same time in most cases, and fabrication time can be saved.

In the "step and repeat" technique, the stepping period of the electron beam to a new location involves wasted time, because the movement and stopping of the stage causes mechanical vibration of the mechanism associated with the stage, due to its inertia. According to the inventors' experience, after the completion of a preceding step movement of the stage, the next patterning operation should be delayed for 0.3 seconds until mechanical vibration is favourably reduced to a small amount. Assuming that the wafer is 10.2 cm (4 inches) in diameter and a square field is 2 mm square, then the above-described wasted time amounts to 520 seconds in total. This wasted time occupies approximately 70% of the whole patterning time of the wafer. From the point of view of throughput of patterned wafers, therefore, the continuously moving stage system is favourable for high-volume production of LSIs.

However, a problem arises which is caused by eddy currents induced in the moving stage, which is subject to a strong magnetic field leaking from a magnetic object lens adjacent to the stage. The problem will be described later in more detail. In relation to this problem, it should be noted that a pole piece of a conventional magnetic object lens has always had a circular bore opened in its lower pole piece which faces a wafer to be processed. The bore is to allow the passage of the scanning electron beam and its scanning in X and Y directions. Basically, the magnetic lens system of an electron beam scanning system has been designed with a rotational axial symmetrical structure, in order to eliminate aberration of the magnetic lenses as far as possible. These appear to be the reasons why a circular bore has been adopted for the magnetic object lens in prior art scanning electron beam apparatus.

In general, the most significant problem with electron beam scanning systems is abberration of the magnetic lens system, and particularly aberration of the magnetic object lens. The electron beam is desirably always projected along the axis of the magnetic lens in order to overcome the aberration problem. Furthermore, the electron beam is desirably projected on to the surface of the wafer perpendicularly, because, if the electron beam is incident on the surface obliquely, distortion or discrepancy of a pattern is frequently caused, due to unevenness or roughness of the surface of the wafer. Such projection of an electron beam on to the wafer is referred to as "normal-landing".

To meet the above-described requirements, an improved electron beam formation and deflection system is employed in te EL3 system of IBM. The magnetic object lens of this system has a variable axis lens (VAL). The technique is disclosed by IBM in U.S. Patent US-A-4 376 249, published on 8th March 1983. The VAL is a magnetic lens utilising an in-lens deflection concept, having two deflection coils and two compensating (or lens axis shifting) coils, and all the coils are provided inside a pole piece of the magnetic object lens. These coils are usually electrically connected in series and are enabled simulataneously. The axis of the VAL is shifted in parallel with the original axis by enabling the compensating coils, operating as a pair, upon deflection of the beam, such that the deflected electron beam runs in coincidence with the shifted lens axis. Since the electron beam always remains on the axis of the VAL, coma aberration and transverse chromatic aberration are favourably eliminated, and normal landing of the electron beam is realised. A wafer to be treated is placed on a stage movable in X-Y directions. When the stage is made of non-magnetic metal, magnetic flux which emanates from the lowermost compensating coil and lands on the stage by penetrating through the wafer, may cause eddy currents in the stage. The pole piece of the VAL has a circular bore at its bottom portion. Consequently, once the stage is moved, eddy currents are induced in the stage, causing a problem of deflection.

In order to eliminate the above-described lowermost compensating coil and to reduce disturbance from external magnetic fields, an improved variable axis magnetic object lens referred to as a variable axis immersion lens (VAIL) has been developed IBM. This is disclosed by IBM in U.S. Patent US-A-4544846, published on 1st October 1985. The VAIL has a lower pole piece, made of ferrite, which has "zero bore" and a wafer to be irradiated by an electron beam is placed on a stage mounted on the lower pole piece. Since the lower pole piece is made of ferromagnetic material, magnetic flux of the object lens lands on the surface of the lower pole piece. With this configuration, the wafer is immersed in the magnetic field and the relevant electron beam lands on the surface of the wafer perpendicularly with the aid of magnetic flux normal to the lower pole piece. Further, since the lower pole piece has no bore and underlies the wafer, the wafer is surrounded by the structure of the VAIL, thus the structure acts as a magnetic "cage". As a result, the electron beam is shielded from external magnetic fields, being free from the disturbance thereof. Thus, the electron beam can have stable normal landing on the wafer. However, with the structural configuration of the VAIL, the stage is also immersed in a strong magnetic field of the VAIL. Once the stage is moved, eddy currents are induced in the stage as described briefly above. The VAIL, therefore, is not suitable for continuously moving stage electron beam exposure lithography.

As described above, both VAL and VAIL are not suitable for use with a continuously moving stage, because of eddy currents induced in the stage which exercise an adverse effect to the electron beam deflection system of the apparatus. The VAL and VAIL are also reported by H. C. Pfeiffer et al in "Microcircuit Engineering", ISBN: 0 12 345750 5, on pp 72 to 81.

According to the present invention there is provided an electron beam exposure apparatus for projecting an electron beam onto an object and scanning the electron beam in a main scanning direction, over a predetermined scanning field or space, the apparatus comprising:-
a movable stage for carrying the object, having a main direction of movement perpendicular to the main scanning direction;
a magnetic lens system including means for emitting electrons, means for focusing the electrons to form the electron beam, and means for deflecting the electron beam, the focusing means having a magnetic object lens means;
the magnetic object lens means comprising:-
a coil for generating magnetic flux,
an upper pole piece made of magnetic material,
a lower pole piece made of magnetic material disposed to face the object carried on the stage,
the magnetic coil, the upper pole piece and the lower pole piece, in combination forming a magnetic lens,
the lower pole piece having a bore, the bore being opened to allow the electron beam to pass therethrough to scan the predetermined scanning field or space of the electron beam,
characterised in that
the shape of the bore opened in the lower pole piece is a stripe or elongate rectangle longitudinally extending in the main scanning direction of the electron beam, having a length much greater than its width, whereby the electron beam is allowed to pass through the bore whilst magnetic flux of the magnetic object lens is substantially prevented from reaching the stage.

An embodiment of the present invention can provide an electron beam exposure apparatus capable of making precise LSI patterns on an object, a wafer for example, which is carried on a continuously moving stage.

An embodiment of the present invention can provide an improved magnetic object lens for use in a beam-forming and scanning system of electron beam exposure apparatus to substantially eliminate or mitigate adverse effects of eddy currents induced in the moving stage.

With a beam-forming and scanning system of an electron beam exposure apparatus, when LSI pattern-making is performed on a wafer which is carried on a continuously moving stage in a predetermined direction, the scanning direction of the electron beam is usually taken to be perpendicular to the moving direction of the stage. Hereby, an adverse effect on scanning of the electron beam can be caused by eddy currents induced in the moving stage which is subject to strong magnetic flux leaking through a circular bore opened in a lower pole piece of the relevant magnetic object lens. The eddy currents produce undesirable magnetic fields which deviate the scanning of the electron beam.

According to an embodiment of the present invention, the adverse effect is eliminated or mitigated by replacing the circular bore of the prior art with a stripe-like opening having a long and narrow mouth and side walls formed in parallel with the axis of the relevant magnetic lens system. The stripe-like opening allows passage of the scanned electron beam therethrough, to be incident on the wafer, for example, with the passage of only a small amount of magnetic lens flux. Consequently, most of the magnetic flux of the magnetic object lens is confined within the internal space of the magnetic object lens and prevented from reaching the continuously moving stage. Also, most of the magnetic flux which does pass through the stripe-like opening runs in parallel with the axis of the magnetic lens system.

As a result, the induction of eddy currents in the moving stage is substantially eliminated, and electron beam scanning is favourably carried out with little deflection error. Further, the magnetic flux which runs through the stripe-like opening in parallel with the axis of the magnetic lens guides electrons to make substantially normal landing on the surface of the wafer. The normal landing of the electrons eliminates or reduces pattern abberration of images formed on the wafer.

Reference is made, by way of example, to the accompanying drawings in which:-
Fig. 1 is a diagram illustrating electron beam exposure apparatus in accordance with an embodiment of the present invention;
Fig. 2 is a schematic cross-sectional view illustrating the structure of a magnetic object lens of a prior art electron beam exposure apparatus;
Fig. 3 is a partially cut-away perspective view of the magnetic object lens of Fig. 2 illustrating relationships between a scanned electron beam and eddy currents induced in a stage;
Fig. 4 is a schematic cross-sectional view of a magnetic object lens in accordance with an embodiment of the present invention;
Fig. 5 is a plan view of a lower pole piece of the magnetic object lens of Fig. 4;
Fig. 6 is a schematic and partially cut-away perspective view of the magnetic object lens shown in Fig. 4; and
Fig. 7(a) and Fig.7(b) are magnified partial cross-sectional views of a portion of the magnetic object lens of Fig. 4, taken in the vicinity of the stripe-like bore (33b) of a lower pole piece of the lens, respectively in a width direction and a longitudinal direction of the bore illustrating distribution of magnetic flux of the magnetic object lens.

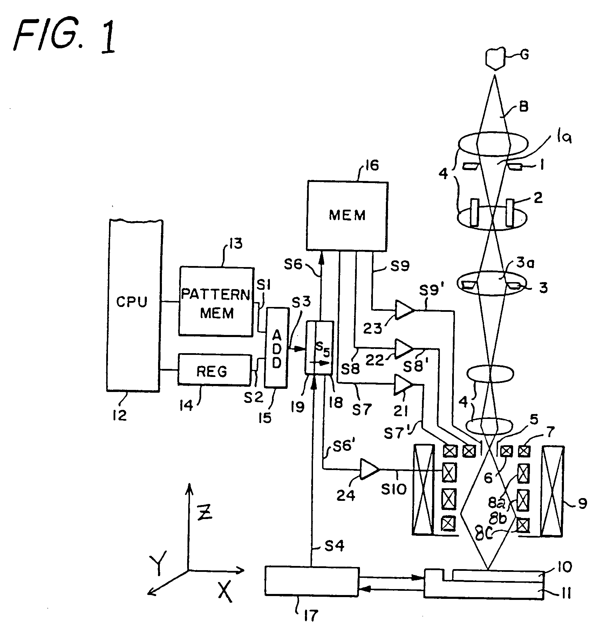

Except for a magnetic object lens, the constitution of the electron beam exposure apparatus of the embodiment of the present invention shown in Fig. 1 is disclosed in U.S. Patent US-A-4 362 942, entitled "Electron Exposure System and an Apparatus for Carrying Out the Same", published on 7th December 1982, and issued to Yasuda, one of the inventors of the present invention. In the embodiment of the present invention, a final magnetic object lens is improved. Hereinafter, the U.S. patent is referred to as "Yasuda" for simplicity.

The electron beam exposure apparatus of Yasuda is usable both with a step and repeat system and with a continuously moving stage system. The improvement offered by the present invention is manifest, in particular, when a continuously moving stage system is employed.

Fig. 1 shows the electron beam exposure apparatus of this embodiment of the present invention. Electrons emitted from an electron gun G are converged and formed into an electron beam B by two convergent magnetic lenses 4 and a magnetic object lens 9 symmetrically disposed along an axis A which extends in a Z direction. The electron beam B passing through the final magnetic lens, namely the magnetic object lens 9, is projected perpendicularly on to a desired position on a surface of a semiconductor wafer 10 placed on a stage 11, movable in X and Y directions, and which (in an exposure operation) is continuously moving in an X direction. Of course, the X, Y and Z directions are perpendicular to each other.

The electron beam B is turned ON and OFF by a beam blanking means (not shown), and the cross-section of the electron beam B is shaped (into rectangular sections of several types) by being intersected through an aperture 1a of a first slit 1 (square aperture), being deflected by a deflection plate 2 and again being intersected by an aperture 3a of a second slit 3 (square aperture), under control of a pattern signal provided from a computer control unit CPU.

The electron beam B thus shaped in response to a pattern signal is deflected by a deflection system comprising two pairs of deflection coils 8a and 8b and a compensating (axis shift) coil 8c, being projected on to a centre point associated with a small first sub-area, which is for example 100 microns square, which is set on the surface of the wafer. Thereafter, the electron beam B is deflected by sub-deflection plates 5 to make a pattern composed of a combination of rectangular patterns of several types in the first sub-area. The deflection plates 5 are controlled electrostatically. 6 and 7 are, respectively, a stigmator coil and a focus coil.

After the completion of pattern formation for the first sub-area, the electron beam B is shifted in the Y direction to be positioned at a centre point of the next, the second, sub-area, and pattern-making for the second sub-area is then carried out under the control of a CPU 12. In such a manner, by repeating electron beam exposures on each sub-area, electron beam exposure pattern-making in respect of a series of sub-areas, for example 20 sub-areas, arranged in the Y direction, for instance, is completed. In other words, pattern-making for a small stripe-like area 100 microns wide and 2 mm long extending in a Y direction on the wafer 10, is completed. So, the Y direction can be referred to as a main scanning direction. Hereinafter, scanning direction means the main scanning direction.

Then, the electron beam is controlled to go back to a new first sub-area, located adjacent to the original first sub-area in the X direction. Thus, a stripe-like zone on the wafer 10 extending in the X direction and having a width of, for example, 2 mm is fully exposed to the irradiating electron beam B. Then the electron beam exposure is shifted to the next stripe-like area of 2 mm width. Finally, the whole surface area of the wafer 10 is patterned by repeating the above-described operations.

As a result, scanning of the electron beam B in the Y direction is limited to within a span of 2 mm, in the above example, and within another narrow span in the X direction, for example with a width of 100 microns. Since the range of scanning of the electron beam B in the X direction is much smaller than the range of scanning in the Y direction, the whole scanning space over which the electron beam B is scanned is limited within a narrow area. The cross-section, perpendicular to the axis A, of the scanning space in the vicinity of the stage 11, is an extremely extended rectangular shape, like a stripe. Hereinafter, this scanning space is referred to as a stripe-like scanning space.

The stage 11 is an extremely rugged and precise mechanism, driven in the X and Y directions by a motor (not shown) to provide the wafer 10 placed thereon with a fine and steady movement in response to a pattern signal. The stage is moved continuously in the X direction. The actual locations of the field coordinates of the wafer 10 placed on the stage 11 are measured by a laser interferometer 17 in Fig. 1. Since the stage 11 is always moved in an X direction during electron beam exposure operations, the projection position of the electron beam B should be always corrected to compensate the movement of the wafer 10 using the actual location of the wafer 10 which is detected by the laser interferometer 17. Other elements illustrated in Fig. 1, such as a stigmator coil 6, a focus coil 7, memories 13, 16, a register 14, an adder 15, a converter 18, a subtractor 19, and amplifiers 21 to 24, are described in Yasuda, and the description thereof is omitted.

Before proceeding further, the above-mentioned adverse effect of deflection of the relevant electron beam caused by eddy currents induced in the moving stage will be described in detail.

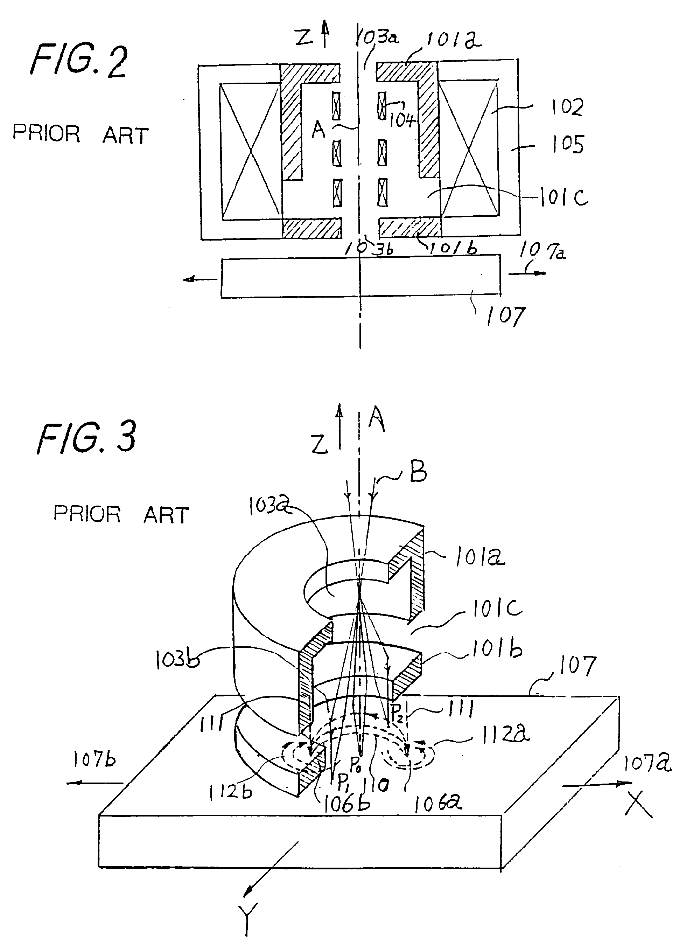

Fig. 2 is a schematic cross-sectional view of a magnetic object lens of a prior art electron beam exposure apparatus, illustrating the structure thereof. The magnetic object lens is symmetrically structured around an axis A extending in the Z direction, comprising an upper pole piece 101a, a lower pole piece 101b facing the upper pole piece 101a and spaced therefrom with an air space 101c, a coil 102 for generating magnetic flux and surrounding the pole pieces 101a, 101b an outer shield 105 enclosing the coil 102 and shielding the magnetic flux to prevent flux leakage outside the object lens, a stage 107 movable in X and Y directions, and deflection coils 104 for deflecting an electron beam B in Y directions. The stage 107 includes a complicated and precise mechanism for moving the stage quickly and accurately, but is represented by a simple plate.

Magnetic flux generated by the coil 102 is guided through the pole pieces 101a and 101b, and emanates in the internal space of the lens forming a magnetic lenses field in the vicinity of the space 101c which exists between pole pieces 101a and 101b. Magnetic flux is prevented from leaking outside the magnetic lens by the magnetic shield 105, and the magnetic flux emanating internally of the lens is terminated at the inner wall surfaces of the pole pieces 101a and 101b. Thus, magnetic flux is basically confined inside the space surrounded by both pole pieces 101a and 101b. However, in the centre of the upper surface of the upper pole piece 101a and of the bottom portion of the lower pole piece 101b, there are formed a circular bore 103a and a circular bore 103b respectively to allow the passage of the electron beam B therethrough. The magnetic flux to be confined inside the magnetic object lens leaks from the bore 103b and intersects the stage 107.

Although the stage 107 may be made of insulative material such as ceramics, plated by a metal layer to avoid electrical charging-up thereof, still some quantity of eddy current is induced in the plated metal layer of the stage and the problem caused by eddy currents occurs. In addition, a mechanism made of magnetic material which is disposed under the ceramic stage and is indispensable to move the stage in X-Y directions also may cause a similar problem.

Fig. 3 is a partly cut-away perspective view of the magnetic object lens shown in Fig. 2, wherein only the stage 107 and pole pieces 101a and 101b are shown. The electron beam B is focused and projected on to a wafer (not shown) at a neutral point P0 without scanning, and is scanned from point P1 to point P2 by a deflection system (not shown). As shown in fig. 3, some leakage flux 111 (shown by broken lines) comes out from the circular bore 103b and intersects the stage 107. The circular shape of the bore 103b is apparently adopted in order to make the whole magnetic lens system rotationally symmetrical around the axis A, to reduce aberration of the magnetic lens system, and to allow the scanning of the relevant electron beam B (shown by solid lines) in both X and Y directions.

When the stage 107 or a portion thereof is made of electrically conductive material and moves in the X direction as indicated by an arrow 107a, there appears a portion 106a on the stage 107 where density of the crossing leakage magnetic flux decreases, and simulataneously a portion 106b where the density increases in line with the movement of the stage 107. These local changes of the magnetic flux density cause eddy currents 112a and 112b (designated by broken-line arrows) at the portions 106a and 106b respectively. Since directions of the eddy current 112a and 112b are opposite to each other, a newly induced magnetic flux 110 (designated by broken lines) runs from the portion 106a to the portion 106b, crossing the path of an electron beam B which projects on to a wafer (not shown) to be processed on the stage 107 as shown in Fig. 2.

As a result, the electron beam B is deviated in the Y direction, namely in a direction perpendicular to the direction (X) of movement of the stage 107. Strictly speaking, deviation of the electron beam B is not always in the Y direction, but can arise in the X direction to some negligibly small degree depending on the structure and material of the stage 107 and relevant mechanism, the magnetic field of the magnetic lens, and the energy intensity of the electron beam B. Ultimately, the deflection of the electron beam B in the Y direction gives rise to adverse effects in any case, resulting in undesirable distortion of patterns depicted on the wafer. In an embodiment of the present invention the aim is to reduce eddy currents in the stage 107 as far as possible, to eliminate the above-described deviation of the electron beam B.

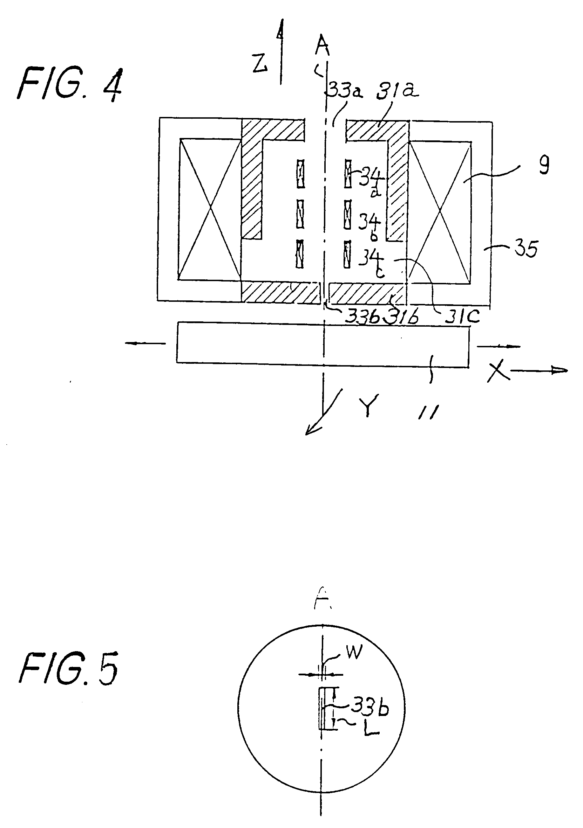

Fig. 4 is a schematic cross-sectional view of a magnetic object lens in accordance with an embodiment of the present invention and Fig. 5 is a plan view of a lower pole piece of the magnetic object lens of Fig. 4. Like the prior art magnetic object lens of Fig. 2, the magnetic object lens shown in Fig. 4 has a rotationally symmetrical structure around an axis A which extends in Z direction, except that for the lens of Fig. 4 a lower pole piece 31b does not have such symmetry. The magnetic object lens of Fig. 4 comprises an upper pole piece 31a, the lower pole piece 31b facing the upper pole piece 31a and spaced apart therefrom by an air space 31c, a coil 9 for generating magnetic flux and surrounding the pole pieces 31a, 31b, an outer shield 35 enclosing the coil 9 and for preventing external leakage of magnetic flux, deflection coils 34a and 34b for deflecting an electron beam B in the Y direction (double deflecting) and a compensation coil 34c for shifting the axis of the magnetic object lens. The lens has three coils for deflection. The coils 34a, 34b and 34c are arranged inside the pole piece 31a. The lower pole piece 31b faces a stage 11 which is movable in the X and Y directions. The lower pole piece 31b also faces a wafer (not shown) placed on the stage 11 during an electron beam exposure operation for patterning a circuit image on the wafer. The stage 11 is conventional, being made of a ceramic plate, the top surface of which has a plated metal layer as described before. The stage 11 includes a complicated and precise mechanism for moving the stage quickly and accurately, but is represented by a simple plate.

Although most of the structure of the magnetic object lens shown in Fig. 5 is the same as that of the prior art magnetic object lens of Fig. 3, there is a significant difference between the two magnetic object lenses; that is the shape of the bore 103b of Fig. 2 or Fig. 3 is circular, allowing the passage of an electron beam B deflected over a predetermined scanning span in any direction, whilst the shape of the opening (bore) 33b of Fig. 4 or Fig. 5 is that of an extremely extended rectangle or a stripe, having a width W and a length L. The dimensions, location, and direction of the stripe-like opening 33b are determined so that the opening 33b allows the electron beam B to pass therethrough whilst magnetic flux coming from the magnetic object lens is stopped (shielded) by the solid portion of the lower pole piece 31b as much as possible. For example, when the predetermined scanning span of the electron beam B in the Y direction is 2 mm and a sub-area of electron beam exposure is 100 microns square, namely when the scanning span of the electron beam B in the X direction is 100 microns, then the above-described dimension L is taken from 20 mm to 40 mm and W is taken from 4 mm to 6 mm. The reason for the selection of such relatively large dimensions for W and L in this case is that smaller dimensions will give rise to mechanical production difficulties in forming the stripe-like opening 31b, it being taken that the material of the lower pole piece 31b is ferrite. Ferrite is preferably selected since it is a ferromagnetic material and has small magnetic hysteresis.

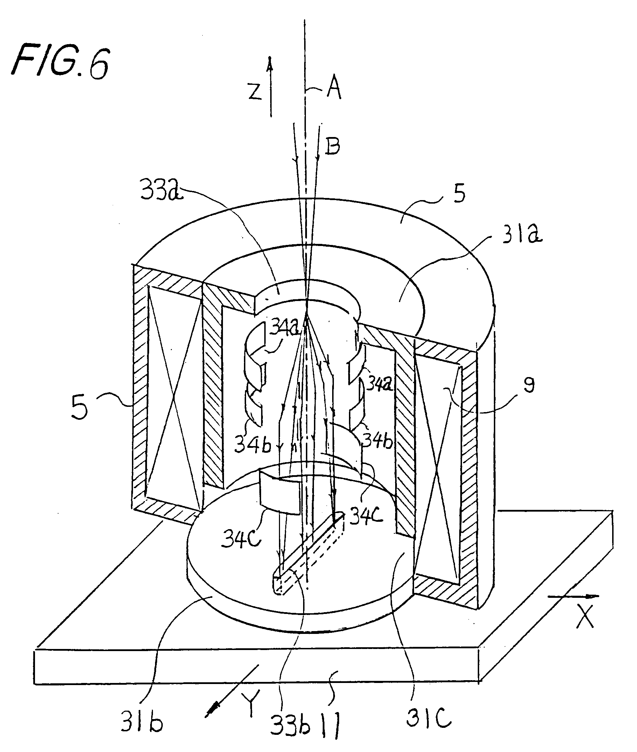

Fig. 6 is a schematic and partly cut-away perspective view of the magnetic object lens shown in Fig. 4, illustrating the positional relationships between the electron beam B and elements of the magnetic object lens. The electron beam B, projected from above th eobject lens (see Fig. 1, for example), is double-deflected by two pairs of deflection coils 34a and 34b and shifted from the centre axis A and directed in parallel with the axis A, according to a control pattern signal sent from a CPU. The axis of the magnetic object lens formed by the pole pieces 31a and 31b, and the coil 9, is simultaneously shifted in the same direction and over the same distance by the compensating coil 34c, such that the shifted axis of the magnetic object lens and the shifted electron beam B coincide with each other, resulting in elimination of off-axis aberration of the lens. Thus, deflected electron beam B passes through the stripe-like bore 33b and lands on a surface of a wafer 10 normally, without axial aberration. This is as advantageous as that of a VAL or a VAIL.

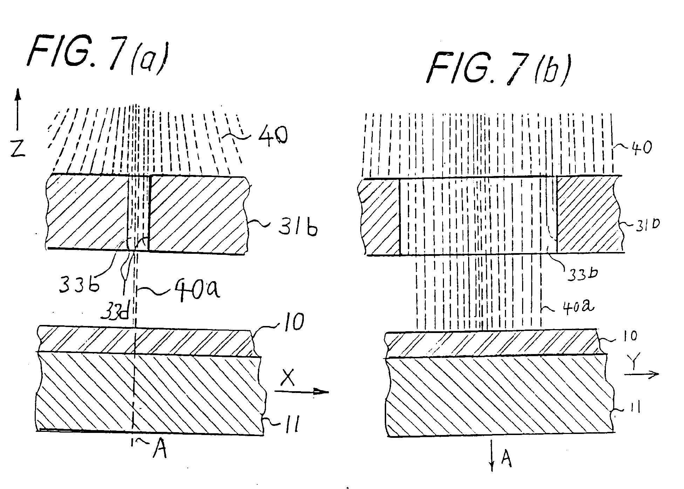

As described above, the wafer 10 placed on the stage 11 is always transferred in the direction X continously with a constant speed. Hereby, as shown in magnified partial central cross-sectional views of Fig. 7(a), which is taken in the X direction, and Fig. 7(b), which is taken in the Y direction, almost all the magnetic flux 40 distributed in the space surrounded by the pole pieces 31a and 31b is intersected by the lower pole piece 31b and prevented from reaching the stage 11.

A small amount of magnetic flux 40a is not intersected by the pole piece 31b, because of the presence of the stripe-like bore 33b. The magnetic flux 40a, which enters into the space inside the stripe-like opening or bore 33b, divides itself into two parts. One part of the magnetic flux may pass through the bore 33b, reaching the wafer 10, whilst the other part of the magnetic flux is deviated and terminates on a side wall of the stripe-like opening 33b.

In a plane extending in the X and Z directions, namely in the width direction of the opening 33b, most of the magnetic flux 40 tends to land on the lower pole piece 31b along lines (orbits) oblique to the surface of the lower pole piece 31b, and a small proportion of magnetic flux 40a passing through regions extremely near to the side walls of the opening 33b, may be terminated at the side walls, as shown in Fig. 7(a). The magnetic flux passing through the centre portion of the width of the opening 33b runs in parallel with the axis A.

In the Y and Z directions, namely in the longitudinal direction of the stripe-like opening 33b, the magnetic flux 40 runs almost in parallel with the axis A, and almost all of the magnetic flux 40a passing through the stripe-like opening 33b runs in parallel with the axis A, as shown in Fig. 7(b). Only a portion of the magnetic flux 40a running through regions extremely near to both ends of the side walls of opening 33b is deflected and terminated to the end side walls.

The electron beam B is scanned with the centre plane which contains the axis A and extends in the Y direction, namely the longitudinal direction of the opening 33b, and the electrons of the beam can make normal landing on the wafer 10. This is a substantial advantage.

In the apparatus described above, a fourth coil equivalent to te lowermost compensating coil of a VAL is not needed. However, by setting a further pair of compensating coils along the side walls 33d (see Fig. 7(a)) extending in the Y direction, further improved normal landing of the electrons may be achieved in a more stable manner.

The magnetic lens field at the lower portion of the magnetic object lens is almost uniform along the Y direction as shown in Fig. 7(b) and so a fourth coil for shifting the axis of th eobject lens for compensation is not needed. In the X direction as shown in Fig. 7(a), the lens field is slightly non-uniform, so that a fourth coil for shifting the lens axis in compensation may be useful.

In order to conduct the above-described electron beam exposure, the side wall of the stripe-like bore 33b is to be accurately finished, and particularly to be formed to be perpendicular to the surface of the disk of the lower pole piece 31b such that the magnetic flux passing through the stripe-like opening 33b is parallel with the axis A.

With the above-described structure of a magnetic object lens according to an embodiment of the present invention, magnetic flux intersecting with the (continuously moving) stage 11 is extremely small and no eddy currents are induced in the stage 11 except for eddy currents arising from the magnetic flux 40a, which are negligibly small. Thus, the adverse effects of eddy currents induced in the moving stage 11, namely deflection aberration, seen in a prior art magnetic object lens, is eliminated or mitigated.

In the above description of a embodiment of the present invention, the electron beam is assumed to be scanned in a single direction, in the Y direction for example. However, it will be apparent that scanning is not limited to a single-direction scanning, scanning may be effected in two or more directions, for example in the manner of a cross, in embodiments of the invention. As long as the electron beam is scanned in a limited and narrow space, embodiments of the present invention are applicable to forming bores of the lower pole piece 31b having a shape corresponding to the scanning pattern of the electron beam and the area of the scanning pattern is favourably small.

Further, in the above-described embodiment, the stage 11 is assumed to be moved continuously. Embodiments of the present invention are also applicable to electron beam exposure apparatus where the stage is moved intermittently.

It should be noted that the lower pole piece 31b prevents magnetic flux issuing from the lower compensating coil 34c located in the vicinity of the stage 11 from inducing eddy current in the stage 11. Otherwise, undesirable magnetic flux may be generated, which has been a problem with the VAL system.

An electron beam exposure apparatus embodying the present invention provides for scanning of an electron beam for electron beam lithography. The range of scanning of the beam is limited and in particular may be limited to scanning in a single direction. A magnetic object lens of the apparatus has a lower pole piece facing an object to be processed (i.e. exposed to the beam) which is placed on a stage for exposure to the electron beam. The stage may be continuously moving. A bore is opened in the lower pole piece which faces the object, the bore having a stripe-like cross-section to allow the passage of the electron beam, to inhibit undesirable leakage of magnetic flux from the magnetic lens towards the object, and to guide the electron beam to land on the object perpendicularly. With this configuration, deflection aberration of the relevant deflection means caused by eddy currents induced in the moving stage due to the magnetic flux reaching the stage is removed or reduced, and normal landing of the electron beam on the object is realised.

## Claims

1. Electron beam exposure apparatus for projecting an electron beam (B) onto an object (10) and scanning the electron beam (B) in a main scanning direction (Y), over a predetermined scanning field or space, the apparatus comprising:-
a movable stage (11) for carrying the object (10), having a main direction (X) of movement perpendicular to the main scanning direction (Y);
a magnetic lens system (G, 4, 9) including means for emitting electrons (G), means (4, 9) for focusing the electrons to form the electron beam (B), and means for deflecting the electron beam (8a, 8b, 8c), the focusing means having a magnetic object lens means (9);
the magnetic object lens means comprising:-
a coil (9) for generating magnetic flux,
an upper pole piece (31a) made of magnetic material,
a lower pole piece (31b) made of magnetic material disposed to face the object (10) carried on the stage (11),
the magnetic coil (9), the upper pole piece (31a) and the lower pole piece (31b), in combination forming a magnetic lens,
the lower pole piece (31b) having a bore (33b), the bore being opened to allow the electron beam (B) to pass therethrough to scan the predetermined scanning field or space of the electron beam (B),
characterised in that
the shape of the bore (33b) opened in the lower pole piece (31b) is a stripe or elongate rectangle longitudinally extending in the main scanning direction (Y) of the electron beam (B), having a length (L) much greater than its width (W), whereby the electron beam (B) is allowed to pass through the bore (33b) whilst magnetic flux of the magnetic object lens is substantially prevented from reaching the stage (11).

2. Apparatus as claimed in claim 1, wherein the magnetic material of the lower pole piece (31b) is ferrite.

3. Apparatus as claimed in claim 1 or 2, wherein the object (10) is a semiconductor wafer.

4. Apparatus as claimed in any preceding claim, wherein side walls of the bore (33b) are formed to be perpendicular to a main surface of the lower pole piece (31b), in which surface the bore (33b) is provided.

5. Apparatus as claimed in any preceding claim, wherein, in an exposure operation of the apparatus, the stage (11) is arranged to move continuously as electron beam scanning of the object (10) is carried out.

## Patentansprüche

1. Elektronenstrahlbelichtungsvorrichtung zum Projizieren eines Elektronenstrahls (B) auf ein Objekt (10) und zum Bestreichen des Elektronenstrahls (B) in eine Abtastrichtung (Y) über ein vorbestimmtes Abtastfeld oder einen Raum, bei der die Vorrichtung umfaßt:
einen bewegbaren Tisch (11), zum Tragen des Objekts (10), der eine Hauptbewegungsrichtung (X) rechtwinklig zu der Hauptabtastrichtung (Y) aufweist,
ein magnetisches Linsensystem (G, 4, 9), enthaltend Mittel zum Emittieren von Elektronen (G), Mittel (4, 9) zum Fokussieren der Elektronen, um einen Elektronenstrahl (B) zu formen, und Mittel zum Ablenken des Elektronenstrahls (8a, 8b, 8c), bei dem die fokussierenden Mittel ein magnetisches Objektlinsenmittel (9) aufweisen,
welches magnetische Objektlinsenmittel umfaßt:
eine Spule (9) zum Erzeugen von magnetischem Fluß,
einen aus magnetischem Material hergestellten oberen Polschuh (31a),
einen aus magnetischem Material hergestellten unteren Polschuh (31b), der dem Objekt (10), das auf einem Tisch (11) getragen wird, zugewandt angeordnet ist,
bei dem die magnetische Spule (9), der obere Polschuh (31a) und der untere Polschuh (31b) in Kombination eine magnetische Linse bilden,
der untere Polschuh (31b), der eine Bohrung (33b) aufweist, welche geöffnet ist, um dem Elektronenstrahl (B) zu erlauben, dort hindurchzupassieren, um das vorbestimmte Abtastfeld oder den Raum des Elektronenstrahls (B) abzutasten,
dadurch gekennzeichnet, daß
die Form der Bohrung (33b), die im unteren Polschuh (31b) geöffnet ist, ein Streifen oder ein längliches Rechteck ist, das sich longitudinal in der Hauptabtastrichtung (Y) des Elektronenstrahls (B) erstreckt, eine Länge (L) hat, die viel größer als seine Weite (W) ist, wodurch dem Elektronenstrahl (B) erlaubt wird, durch die Bohrung (33b) zu passieren, während der magnetische Fluß der magnetischen Objektlinse im wesentlichen am Erreichen des Tisches (11) gehindert wird.

2. Vorrichtung nach Anspruch 1, bei der das magnetische Material des unteren Polschuhs (31b) Ferrit ist.

3. Vorrichtung nach Anspruch 1 oder 2, bei der das Objekt (10) ein Halbleiterwafer ist.

4. Vorrichtung nach einem der vorhergehenden Ansprüche, bei der die Seitenwände der Bohrung (33b) rechtwinklig zu einer Hauptoberfläche des unteren Polschuhs (31b), in dessen Oberfläche die Bohrung (33b) vorgesehen ist, geformt sind.

5. Vorrichtung nach einem der vorhergehenden Ansprüche, bei der in einem Belichtungsvorgang der Vorrichtung der Tisch (11) arrangiert ist, um sich kontinuierlich zu bewegen, wenn die Elektronenstrahlabtastung des Objekts (10) durchgeführt wird.

## Revendications

1. Dispositif d'exposition à un faisceau d'électrons pour projeter un faisceau d'électrons (B) sur un objet (10) et pour déplacer le faisceau d'électrons (B) dans une direction principale de balayage (Y), sur un domaine ou espace de balayage prédéterminé, le dispositif comprenant :
une platine mobile (11) pour porter l'objet (10), ayant une direction principale de déplacement (X) perpendiculaire à la direction principale de balayage (Y) ;
un système de lentilles magnétiques (G, 4, 9) comprenant un moyen d'émission d'électrons (G) pour émettre des électrons, un moyen de focalisation (4, 9) pour focaliser les électrons pour former le faisceau d'électrons (B), et un moyen de déviation (8a, 8b, 8c) pour dévier le faisceau d'électrons, le moyen de focalisation comportant un moyen formant lentille magnétique d'objectif (9) ;
le moyen formant lentille magnétique d'objectif comprenant :
une bobine (9) pour produire un flux magnétique ;
une pièce polaire supérieure (31a) faite d'une matière magnétique ;
une pièce polaire inférieure (31b) faite d'une matière magnétique disposée en face de l'objet (10) porté sur la platine (11) ;
la bobine magnétique (9), la pièce polaire supérieure (31a) et la pièce polaire inférieure (31b) formant, en combinaison, une lentille magnétique ;
la pièce polaire inférieure (31b) ayant un orifice (33b), l'orifice étant ouvert pour permettre au faisceau d'électrons (B) de passer à travers pour balayer le domaine, ou espace, de balayage prédéterminé du faisceau d'électrons (B) ;
caractérisé en ce que :
la forme de l'orifice (33b) ouvert dans la pièce polaire inférieure (31b) est une bande, ou rectangle allongé, s'étendant longitudinalement dans la direction principale de balayage (Y) du faisceau d'électrons (B), ayant une longueur (L) beaucoup plus grande que sa largeur (W), ce par quoi le faisceau d'électrons (B) peut passer à travers l'orifice (33b) tandis que le flux magnétique de la lentille magnétique d'objectif est sensiblement empêché d'atteindre la platine (11).

2. Dispositif selon la revendication 1, dans lequel la matière magnétique de la pièce polaire inférieure (31b) est de la ferrite.

3. Dispositif selon la revendication 1 ou 2, dans lequel l'objet (10) est une plaquette de semi-conducteur.

4. Dispositif selon l'une quelconque des revendications précédentes, dans lequel les parois latérales de l'orifice (33b) sont formées de manière à être perpendiculaires à la face principale de la pièce polaire inférieure (31b), face dans laquelle est ménagé l'orifice (33b).

5. Dispositif selon l'une quelconque des revendications précédentes, dans lequel, dans une opération d'exposition du dispositif, la platine (11) est conçue pour se déplacer en continu pendant le balayage de l'objet (10) par le faisceau d'électrons.
